Europäisches Patentamt

European Patent Office

Office européen des brevets

(11) Veröffentlichungsnummer: **0 482 455 A2**

## (12) EUROPÄISCHE PATENTANMELDUNG

(21) Anmeldenummer: **91117414.2**

(22) Anmeldetag: **11.10.91**

(51) Int. Cl.⁵: **G02B 6/12**

(30) Priorität: **25.10.90 DE 4034000**

(43) Veröffentlichungstag der Anmeldung:
**29.04.92 Patentblatt 92/18**

(84) Benannte Vertragsstaaten:
**DE FR GB IT**

(71) Anmelder: **SIEMENS AKTIENGESELLSCHAFT**
**Wittelsbacherplatz 2**
**W-8000 München 2(DE)**

(72) Erfinder: **Schimpe, Robert, Dr.**
**Georg-Kerschensteiner-Strasse 56**
**W-8012 Hohenbrunn/Riemerling(DE)**

(54) Bauelement mit integriertem Wellenleiter mit entspiegelten Endflächen.

(57) Bauelement mit einem integrierten Wellenleiter (3) aus Halbleitermaterial mit vergrabenen Endflächen (8), deren Flächennormalen (21) im Winkel zu der Längsrichtung (15) des Wellenleiters (3) verläuft.

FIG 2

EP 0 482 455 A2

Die vorliegende Erfindung betrifft ein Bauelement mit einem integrierten Wellenleiter mit entspiegelten Endflächen.

Bei optoelektronischen Bauelementen, in denen Wellenleiter integriert sind, ergibt sich das Erfordernis, die Endflächen dieser Wellenleiter zu entspiegeln, um eine möglichst niedrige Reflexion bei der Auskopplung von Strahlung zu erreichen. Insbesondere für optische Verstärker sind häufig Restreflexionen unter 0,1 % erforderlich.

Die Entspiegelung der Endflächen von Wellenleitern kann auf unterschiedliche Weise erfolgen.

In Electron, Lett., Vol. 24, pp. 569 - 570, 1988, von N.A. Olsson wird die Beschichtung der Endflächen des Resonators eines Halbleiterlaserverstärkers mit einer dielektrischen Schicht beschrieben. Um die geforderte geringe Restreflexion zu erreichen, müssen enge Toleranzen bei der Herstellung der Beschichtung eingehalten werden. Geringe Restreflexion wird nur in einem schmalen Wellenlängenband erzielt.

In Electron. Lett., Vol. 29, pp. 825 - 827, 1990, von P.E. Barnsley et al. wird ein optischer Halbleiterverstärker beschrieben, dessen Wellenleiter schräg zur Normalen der Halbleiterspaltfläche verläuft. Zum Erreichen geringer Restreflexion muß ein großer Ablenkwinkel (20 bis 45°) der Lichtemission bezüglich der Normalen zur Halbleiterspaltfläche in Kauf genommen werden. Große Ablenkwinkel sind für die Ankopplung einer Glasfaser an den Chip von Nachteil.

In Electron. Lett., Vol. 25, pp. 242 - 243, 1989, von I. Cha et al.; und in J. Appl. Phys., Vol. 67, pp. 3943 - 3947, 1990, von N.K. Dutta et al. werden optische Verstärker mit vergrabener Wellenleiterendfläche beschrieben. Zur Entspiegelung der Spaltfläche wird, abhängig von der Wellenleiterstruktur, ein Abstand von 5 - 20 $\mu$m zwischen der vergrabenen Endfläche und der Spaltfläche gewählt. Die Wirksamkeit des Entspiegelungsverfahrens ist begrenzt durch Reflexion an der Endfläche des Wellenleiters im Innern des Halbleitermaterials.

Aufgabe der vorliegenden Erfindung ist es, ein Bauelement mit integriertem Wellenleiter anzugeben, bei dem die Endflächen dieses Wellenleiters auf möglichst einfache Weise möglichst effizient entspiegelt sind.

Diese Aufgabe wird mit dem Bauelement mit den Merkmalen des Anspruches 1 gelöst. Weitere Ausgestaltungen ergeben sich aus den Unteransprüchen.

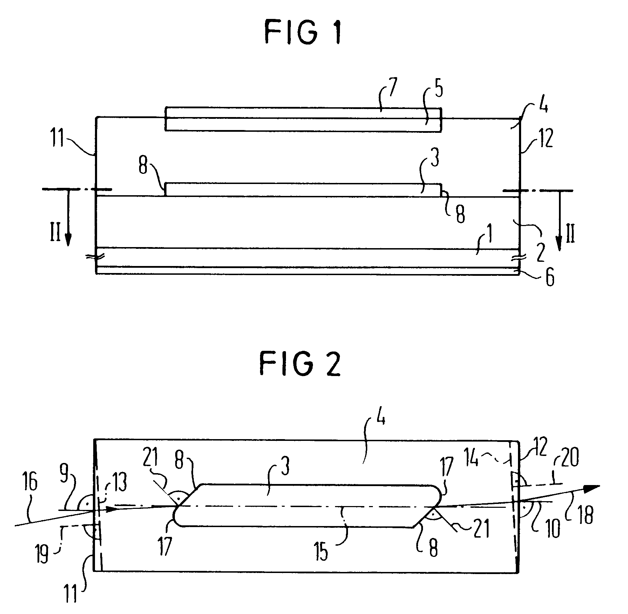

Die Entspiegelung der Endflächen des Wellenleiters erfolgt erfindungsgemäß dadurch, daß der Wellenleiter mit vergrabenen Endflächen ausgebildet wird und diese Endflächen zu der Längsrichtung des Wellenleiters schräg verlaufen. D. h. die Flächennormale auf diese Endflächen ist nicht parallel zu der Längsachse des Wellenleiters. Insbesondere ist diese Erfindung bei Halbleiterbauelementen anwendbar, bei denen der Wellenleiter ein Halbleitermaterial ist, das sich im Brechungsindex von dem umgebenden Material unterscheidet. Es folgt eine Beschreibung des erfindungsgemäßen Aufbaus anhand der Fig. 1 bis 4, von denen die Fig. 1, 3 und 4 den erfindungsgemäßen Aufbau für ein Halbleiterbauelement im Querschnitt und die Fig. 2 den in Fig. 1 eingezeichneten Schnitt parallel zur überwachsenen Oberfläche des Substrates zeigt.

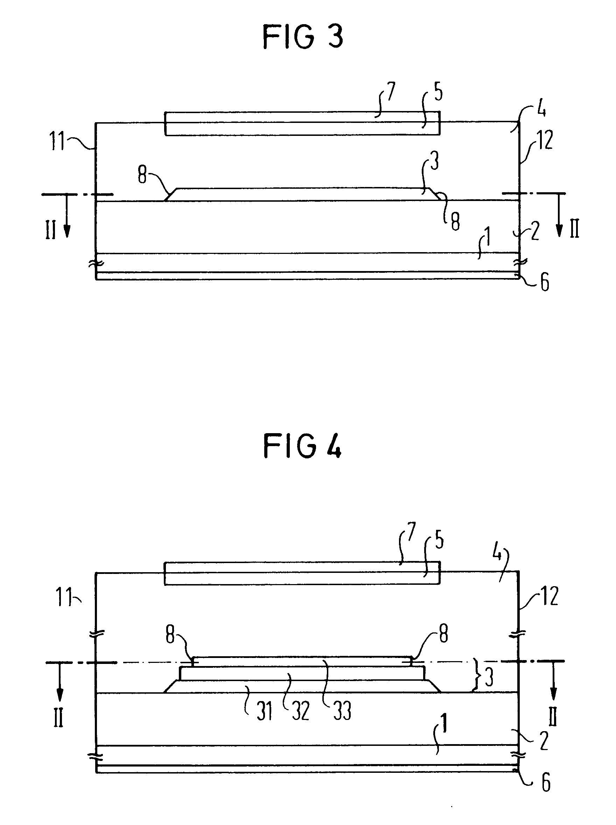

Bei dem Aufbau nach Fig. 1 handelt es sich um eine schematische Darstellung der erfindungswesentlichen Bestandteile des Halbleiterbauelementes. Dieser Aufbau kann in beliebiger Weise durch weitere Elemente erweitert sein. Auf ein Substrat 1 ist eine untere Mantelschicht 2 aufgewachsen. Auf dieser unteren Mantelschicht 2 befindet sich eine streifenförmige Schicht als Wellenleiter 3, die von oben mit einer oberen Mantelschicht 4 bedeckt ist. Diese obere Mantelschicht 4 begrenzt den Wellenleiter 3 auch lateral und in Längsrichtung. Dadurch ergeben sich die vergrabenen Endflächen 8. Diese Endflächen 8 sind in Fig. 1 so eingezeichnet, daß sie senkrecht verlaufen, sie können aber auch geneigt sein, wie in Fig. 3 dargestellt ist. Das Halbleitermaterial der Mantelschichten 2, 4 hat einen niedrigeren Brechungsindex als das Halbleitermaterial des Wellenleiters 3. Damit ergibt sich eine Strahlungsführung in dem Wellenleiter 3. Durch Stromzufuhr kann der Wellenleiter 3 als aktive Schicht zur Strahlungserzeugung betrieben werden. In Fig. 1 sind eine hoch dotierte Kontaktschicht 5 und Elektroden als Metallkontakte 6, 7 auf der Unterseite des Substrats bzw. auf dieser Kontaktschicht 5 eingezeichnet. Bei einem Aufbau im Materialsystem InP/InGaAsP bestehen das Substrat 1 und die untere Mantelschicht 2 z. B. aus n-dotiertem InP, der Wellenleiter als aktive Schicht aus 1,56 $\mu$m-InGaAsP, die obere Mantelschicht 4 aus p-dotiertem InP und die Kontaktschicht 5 z. B. aus hoch p-dotiertem InGaAsP. Ebenso ist ein Aufbau im Materialsystem von GaAs oder anderen Halbleitermaterialsystemen möglich.

Wesentlich ist dabei, daß der Wellenleiter 3 vergraben ist, d. h. die Endflächen 8 des Wellenleiters 3 grenzen jeweils an weiteres Halbleitermaterial, in diesem Fall das Material der oberen Mantelschicht 4. Die Endflächen 8 des Wellenleiters 3 sind daher in einem Abstand zu den äußeren Grenzflächen 11, 12, die die Grenze zwischen dem Halbleitermaterial und der umgebenden Luft bilden, angeordnet. Außerdem sind die Endflächen 8 relativ zur Längsrichtung, d. h. der Ausbreitungsrichtung der Strahlung, schräggestellt. Die Flächennormale 21 auf den Endflächen 8 (s. Fig. 2) ist daher nicht parallel zu dieser Längsrichtung 15. In dem angegebenen Ausführungsbeispiel ist der Wellen-

leiter 3 0,4 $\mu$m dick und 1,6 $\mu$m breit. Die Anwendung der vorliegenden Erfindung ist bei einer Dicke des Wellenleiters 3 von mindestens 0,1 $\mu$m besonders vorteilhaft. Die Endflächen 8 des Wellenleiters 3 können seitlich Verrundungen 17 wie in Fig. 2 aufweisen. Das Bauelement als Ganzes kann so geformt sein, daß die äußeren Grenzflächen 11, 12 des Halbleitermateriales zur umgebenden Luft Flächennormalen 9, 10 haben, die parallel zur Längsrichtung 15 des Wellenleiters 3 verlaufen. In Fig. 2 verlaufen beide Endflächen 8 des Wellenleiters 3 schräg, so daß der Strahlengang des einfallenden Lichtstrahles 16 wegen der zwei vorhandenen Grenzflächen zwischen Materialien unterschiedlichen Brechungsindexes zwei Knickstellen aufweist. Die betreffende äußere Grenzfläche 13 kann auch eine Normale 19 haben, die einen von 0 verschiedenen Winkel mit der Längsrichtung 15 bildet. Diese Flächennormale 19 auf die äußere Grenzfläche 13 verläuft aber in der von der Flächennormalen 21 auf die Endfläche 8 des Wellenleiters 3 und die Längsrichtung 15 festgelegten Ebene. Die Flächennormale 19 an die äußere Grenzfläche 13 ist aus der Längsrichtung 15 in dem entgegengesetzten Drehsinn gedreht wie die Flächennormale 21 an die Endfläche 8 des Wellenleiters 3, wie in Fig. 2 gezeigt. Damit wird erreicht, daß der Strahlengang 16 des einfallenden Lichtes außerhalb des Bauelementes parallel zu der Flächennormalen 19 verläuft. Wenn die äußere Grenzfläche 13 noch schräger angeordnet ist, ist der Strahlengang 16 außerhalb des Halbleiterbauelementes wieder parallel zu der Längsrichtung 15 und wird aber wegen des zweimaligen Übergangs zwischen Materialien unterschiedlichen Brechungsindexes zweimal abgeknickt und damit als Ganzes parallel verschoben. Entsprechend kann auch die äußere Grenzfläche 14 auf der Seite des austretenden Lichtes so schräg angeordnet sein, daß die Flächennormale 20 auf diese äußere Grenzfläche 14 parallel zu dem Strahlengang 18 des austretenden Lichtes verläuft. Auch hier erreicht man bei einer noch schrägeren Anordnung, daß der Strahlengang an der Übergangsgrenze zwischen Halbleitermaterial und Luft soweit abgeknickt wird, daß er anschließend parallel zu der Längsrichtung 15 verläuft. Damit ist entweder ein leichteres Ankoppeln einer äußeren Glasfaser oder ein insgesamt linearer Durchgang des Lichtes durch das Bauelement gewährleistet.

Die äußeren Grenzflächen 11, 12 bzw. 13, 14 können außerdem in einer herkömmlichen Weise mit einer dielektrischen Schicht entspiegelt sein. Die erfindungsgemäße Struktur des integrierten Wellenleiters kann auch bei einem Aufbau mit Stegwellenleiter angewendet sein. Als Endfläche des Wellenleiters kann auch ein abrupter Übergang eines Abschnittes mit enger Strahlungsbegrenzung in einen Abschnitt ohne laterale Begrenzung aufgefaßt werden. In diesem Fall grenzt der Wellenleiter mit seiner Endfläche an das gleiche Material, aus dem der Wellenleiter selbst besteht, ist aber lateral durch anderes Material begrenzt. Der Wellenleiter braucht nicht aus Halbleitermaterial zu bestehen, sondern kann irgendein für Wellenleiter gebräuchliches Material sein, das in ensprechend gebräuchliches Material (nicht notwendig Halbleitermaterial) eingebettet ist. Für den Wellenleiter kommt z. B. eine Zusammensetzung aus $Si_3N_4$ und $SiO_x$ in Frage. Das umgebende Material ist dann z. B. $SiO_2$.

Die vergrabenen Endflächen 8 können erfindungsgemäß entsprechend der Fig. 2 um eine vertikale Achse gedreht sein oder entsprechend Fig. 3 um eine horizontale Achse oder um beide Achsen, so daß die Flächennormalen 21 nicht wie üblich parallel zu der Längsrichtung 15 verlaufen. Im Fall einer Drehung um beide Achsen ist wegen der gebräuchlichen Abmessungen der Querschnittsfläche des Wellenleiters 3 zu berücksichtigen, daß die Drehung um die vertikale Achse entsprechend Fig. 2 stärker ins Gewicht fällt, also hierbei ein kleinerer Winkel zwischen der Flächennormalen 21 und der Längsrichtung 15 ausreicht als im Fall einer Drehung um eine horizontale Achse wie in Fig. 3.

Die erfindungsgemäß entspiegelten Endflächen 8 können auch gekrümmt sein, so daß die Flächennormalen 21 nicht parallel zueinander sind. Die Endflächen 8 sind dann auch entsprechend den obigen Ausführungsbeispielen aus einer zu der Mittelachse des Wellenleiters 3 symmetrischen Lage gedreht.

Vorteilhaft im Fall einer Drehung um die horizontale Achse (Fig. 3) ist ein Winkel von etwa 45° zwischen der Flächennormalen 21 bzw. einer bei einer schwach gekrümmten Endfläche 8 repräsentativen Flächennormalen und der Längsrichtung 15.

Einen mehrlagigen Aufbau des Wellenleiters 3 zeigt die Fig. 4. Der Wellenleiter 3 umfaßt hierbei z.B. drei Schichten 31, 32, 33, von denen mindestens eine Schicht (31) erfindungsgemäß abgeschrägte Endflächen besitzt. Eine mögliche Schichtfolge für ein dementsprechendes Ausführungsbeispiel umfaßt eine untere Wellenleiterschicht 31 (z.B. n-InGaAsP der Wellenlänge $\approx$ 1,3 $\mu$m), eine Zwischenschicht 32 (z.B. n-InP) und eine obere Wellenleiterschicht 33 als aktive Schicht (z.B. undotiertes InGaAsP der Wellenlänge $\approx$ 1,5 $\mu$m). Die Zwischenschicht 32 kann auch fehlen oder umgekehrt dotiert als gemeinsame Stromzuführung für die untere Wellenleiterschicht 31 und die obere Wellenleiterschicht 33 dienen. Stattdessen kann die mittlere Schicht 32 als aktive Schicht fungieren, die dann z.B. InGaAsP einer Wellenlänge von etwa 1,5 $\mu$m ist und die von der unteren Wellenleiterschicht 31 und von der oberen Wellenleiterschicht 33 aus jeweils InGaAsP einer Wellenlänge von etwa 1,3 $\mu$m vertikal begrenzt wird.

Ein besonderer Vorteil der erfindungsgemäßen Anordnung ist darin zu sehen, daß die Reflexivität einer vergrabenen Endfläche eines Wellenleiters wesentlich reduziert werden kann, ohne daß die Richtung der Strahlung beim Auskoppeln aus dem Wellenleiter wesentlich abgelenkt wird. Andererseits kann durch schräge vergrabene Endflächen die Abstrahlung von der äußeren Grenzfläche unter einem solchen vorbestimmten Ablenkwinkel erfolgen, daß die Reflexion an dieser äußeren Grenzfläche in den Wellenleiter zurück verringert wird. Der zur Entspiegelung der äußeren Grenzfläche erforderliche Minimalabstand zwischen der vergrabenen Endfläche und dieser äußeren Grenzfläche kann durch die schräge Anordnung der Endfläche des Wellenleiters reduziert werden. Durch die Kombination schräger Endflächen des Wellenleiters mit schrägen äußeren Grenzflächen kann die Reflexion minimiert und der Strahlengang weiter optimiert werden.

**Patentansprüche**

1. Bauelement auf einem Substrat (1) mit einem integrierten Wellenleiter (3) mit einer Längsrichtung (15), mit einer in dieser Längsrichtung (15) verlaufenden Mittelachse und mit einer vergrabenen Endfläche (8), bei dem der Inhalt der auf dieser Längsrichtung (15) senkrecht stehenden Querschnittsfläche des Wellenleiters (3) zu dieser Endfläche (8) hin abnimmt und bei dem der Abstand zwischen dem Schwerpunkt der auf der Längsrichtung (15) senkrecht stehenden Querschnittsfläche des Wellenleiters (3) und dieser Mittelachse des Wellenleiters (3) zu dieser Endfläche (8) hin zunimmt.

2. Bauelement nach Anspruch 1, bei dem der Inhalt der auf der Längsrichtung (15) senkrecht stehenden Querschnittsfläche des Wellenleiters (3) in einem vor der Endfläche (8) befindlichen Abschnitt des Wellenleiters (3) streng monoton abnimmt.

3. Bauelement nach Anspruch 1, bei dem der Inhalt der auf der Längsrichtung (15) senkrecht stehenden Querschnittsfläche des Wellenleiters (3) in einem vor der Endfläche (8) befindlichen Abschnitt des Wellenleiters (3) in mindestens einer Stufe abnimmt.

4. Bauelement nach Anspruch 1 oder 2, bei dem die Endfläche (8) eine Flächennormale (21) hat, die nicht parallel zu der Längsrichtung (15) des Wellenleiters (3) verläuft.

5. Bauelement nach Anspruch 4, bei dem die Projektion einer Flächennormalen (21) der Endfläche (8) in die Ebene der dem Wellenleiter (3) zugewandten Oberfläche des Substrats (1) und die Längsrichtung (15) des Wellenleiters (3) einen von null verschiedenen Winkel bilden.

6. Bauelement nach einem der Ansprüche 1 bis 5, bei dem die vergrabene Endfläche (8) an Material angrenzt, das einen anderen Brechungsindex hat als das Material des Wellenleiters (3).

7. Bauelement nach einem der Ansprüche 1 bis 5, bei dem die vergrabene Endfläche (8) an Material angrenzt, das einen niedrigeren Brechungsindex hat als das Material des Wellenleiters.

8. Bauelement nach einem der Ansprüche 1 bis 7, bei dem das an die vergrabene Endfläche (8) außerhalb des Wellenleiters (3) angrenzende Material in Längsrichtung (15) des Wellenleiters eine äußere Grenzfläche (11, 12) hat, deren Flächennormale (9, 10) parallel zu dieser Längsrichtung (15) verläuft.

9. Bauelement nach einem der Ansprüche 1 bis 7, bei dem das an die vergrabene Endfläche (8) außerhalb des Wellenleiters (3) angrenzende Material in Längsrichtung (15) des Wellenleiters eine äußere Grenzfläche (13, 14) hat, deren Flächennormale (19, 20) nicht parallel zu dieser Längsrichtung (15) verläuft.

10. Bauelement nach einem der Ansprüche 1 bis 9, bei dem der Wellenleiter (3) in der Längsrichtung (15) an zwei gegenüberliegenden Enden durch vergrabene Endflächen (8) begrenzt ist, bei dem der Inhalt der auf der Längsrichtung (15) senkrecht stehenden Querschnittsfläche des Wellenleiters (3) zu jeder Endfläche (8) hin abnimmt und bei dem der Abstand zwischen dem Schwerpunkt der auf der Längsrichtung (15) senkrecht stehenden Querschnittsfläche des Wellenleiters (3) und der Mittelachse des Wellenleiters (3) zu jeder Endfläche (8) hin zunimmt.

11. Bauelement nach einem der Ansprüche 1 bis 10, bei dem der Wellenleiter (3) Halbleitermaterial ist.

**12.** Bauelement nach einem der Ansprüche 1 bis 10, bei dem der Wellenleiter (3) kein Halbleitermaterial ist.

**13.** Bauelement nach Anspruch 11, bei dem der Wellenleiter (3) durch eine aktive Schicht zwischen Mantelschichten (2, 4) aus Halbleitermaterial gebildet ist.

# FIG 1

# FIG 2

EP 0 482 455 A2

## FIG 3

## FIG 4

7